# EUROPEAN PATENT SPECIFICATION

(11) **EP 4 571 853 B1**
(45) Date of publication and mention of the grant of the patent: **03.06.2026**
(21) Application number: 24167891.1
(22) Date of filing: 29.03.2024
(51) Int. Cl.: H10F 10/165, H10F 71/00, H10F 77/20, H10F 77/30

(54) **SOLAR CELL AND METHOD OF PRODUCING A SOLAR CELL**
SOLARZELLE UND VERFAHREN ZUR HERSTELLUNG EINER SOLARZELLE
CELLULE SOLAIRE ET PROCÉDÉ DE FABRICATION D'UNE CELLULE SOLAIRE

(30) Priority: 14.12.2023 CN 202311715970
(43) Date of publication of application: 18.06.2025
(73) Proprietor: Trina Solar Co., Ltd, Changzhou, Jiangsu 213031 (CN)
(72) Inventor: YANG, Guangtao, Changzhou 213031 (CN)
(74) Representative: Nederlandsch Octrooibureau

(56) References cited:
- US-A1- 2018 083 149
- US-A1- 2019 019 904

## Description

### Technical field

This disclosure mainly relates to the field of solar energy technology and specifically relates to a solar cell and method of producing a solar cell.

### Background

Solar cells can convert light energy into electrical energy. The principle of solar cells is the photovoltaic effect. Specifically, when sunlight illuminates the solar cell, electron-hole pairs are generated in the N region and P region inside the solar cell. Then the electrons are pushed to the N region by the electric field, and the holes are pushed to the P region by the electric field. Improving the efficiency of solar cells can improve the ability of solar cells to generate electrical energy. Therefore, how to improve the efficiency of solar cells has always been one of the important research directions.

US 2019/019904 A1 discloses solar cell fabrication using laser patterning of ion-implanted etch-resistant layers, and the resulting solar cells. In an example, a back contact solar cell includes an N-type single crystalline silicon substrate having a light-receiving surface and a back surface. Alternating continuous N-type emitter regions and segmented P-type emitter regions are disposed on the back surface of the N-type single crystalline silicon substrate, with gaps between segments of the segmented P-type emitter regions. Trenches are included in the N-type single crystalline silicon substrate between the alternating continuous N-type emitter regions and segmented P-type emitter regions and in locations of the gaps between segments of the segmented P-type emitter regions. An approximately Gaussian distribution of P-type dopants is included in the N-type single crystalline silicon substrate below the segmented P-type emitter regions. A maximum concentration of the approximately Gaussian distribution of P-type dopants is approximately in the center of each of the segmented P-type emitter regions between first and second sides of each of the segmented P-type emitter regions. Substantially vertical P/N junctions are included in the N-type single crystalline silicon substrate at the trenches formed in locations of the gaps between segments of the segmented P-type emitter regions.

US 2018/083149 A1 discloses a solar cell including a control passivation film on one surface of a semiconductor substrate, and being formed of a dielectric material; and a semiconductor layer on the control passivation film, wherein the semiconductor layer including a first conductive region having a first conductive type and a second conductive region having a second conductive type opposite to the first conductive type. The semiconductor substrate includes a diffusion region including at least one of a first diffusion region and a second diffusion region adjacent to the control passivation film, wherein the first diffusion region being locally formed to correspond to the first conductive region and having a doping concentration lower than a doping concentration of the first conductive region, wherein the second diffusion region being locally formed to correspond to the second conductive region and having a doping concentration lower than a doping concentration of the second conductive region.

### Summary

The technical problem to be solved by this disclosure is to provide a solar cell and a method of producing a solar cell, which has the advantages of high efficiency and low cost.

The solution to the problem is according to the claims.

### Description of the Drawings

The drawings are included to provide a further understanding of the present application, and they are included and constitute a part of the present application, the drawings show the embodiments of the present application, and serving to explain the principles of the present application together with the description. In the drawings:
Fig. 1 is a schematic cross-sectional view of a solar cell according to an embodiment of the present disclosure;
Fig. 2 is a schematic cross-sectional view of a solar cell according to another embodiment of the present disclosure;
Fig. 3 is a schematic cross-sectional view of a solar cell according to an embodiment of the present disclosure;
Fig. 4 is a schematic flow chart of a method of producing a solar cell according to an embodiment of the present disclosure;
Figs. 5 to 12 are schematic cross-sectional views of intermediate products during the process of producing a solar cell according to a method of producing a solar cell in an embodiment of the present disclosure;
Figs. 13 to 17 are schematic cross-sectional views of intermediate products during the process of producing a solar cell according to a method of producing a solar cell in another embodiment of the present disclosure;
Figs. 18 to 19 are schematic cross-sectional views of an intermediate product of a solar cell during the process of forming an isolation groove in an embodiment of the present disclosure.

### Detailed Description

In order to explain the technical solutions of the embodiments of the present application more clearly, the following will briefly introduce the drawings needed to describe the embodiments. Obviously, the drawings in the following description are only some examples or embodiments of the present application. For those of ordinary skill in the art, without exerting creative efforts, the present application can also be applied into other similar scenarios according to these drawings. Unless obvious from the locale or otherwise stated, the same reference numbers in the figures represent the same structure or operation.

As shown in this application and claims, words such as "a", "an", "an" and/or "the" do not specifically refer to the singular and may include the plural unless the context clearly indicates an exception. Generally speaking, the terms "comprising" and "including" only imply the inclusion of clearly identified steps and elements, and these steps and elements do not constitute an exclusive list. The method or apparatus may also include other steps or elements.

The relative arrangement of components and steps, numerical expressions, and numerical values set forth in these examples do not limit the scope of the application unless specifically stated otherwise. At the same time, it should be understood that, for convenience of description, the dimensions of various parts shown in the drawings are not drawn according to actual proportional relationships. Techniques, methods and devices known to those of ordinary skill in the relevant art may not be discussed in detail, but where appropriate, such techniques, methods and devices should be considered part of the authorized specification. In all examples shown and discussed herein, any specific values are to be construed as illustrative only and not as limiting. Accordingly, other examples of the exemplary embodiments may have different values. It should be noted that similar reference numerals and letters refer to similar items in the following figures, so that once an item is defined in one figure, it does not require further discussion in subsequent figures.

In the description of this application, it should be understood that the orientation indicated by directional words such as "front, back, up, down, left, right", "horizontal, vertical, vertical, horizontal" and "top, bottom", etc. Or the positional relationship is usually based on the orientation or positional relationship shown in the drawings, which are only for the convenience of describing the present application and simplifying the description. Without explanation to the contrary, these directional words do not indicate and imply the referred devices or components. It must have a specific orientation or be constructed and operated in a specific orientation, so it cannot be understood as limiting the scope of the present application; the orientation words "inside and outside" refer to the inside and outside relative to the outline of each component itself.

For the convenience of description, spatially relative terms can be used here, such as "on...", "above...", "on the upper surface of...", "on top of", etc., to describe the spatial relationship between one device or feature and other devices or features as shown in the figure. It should be understood that the spatially relative terms are intended to encompass different orientations of the device in use or operation in addition to the orientation depicted in the figures. For example, if a device in the figure is turned upside down, then one device described as "above other devices or configurations" or "on top of other devices or configurations" would then be oriented as "below other devices or configuration" or "beneath other devices or configurations". Thus, the exemplary term "over" may include both orientations "above" and "below." The device may be otherwise oriented (rotated 90 degrees or at other orientations) and the spatially relative descriptors used herein interpreted accordingly.

In addition, it should be noted that the use of words such as "first" and "second" to define parts is only to facilitate the distinction between corresponding parts. Unless otherwise stated, the above words have no special meaning and therefore cannot be understood as limiting the scope of protection of this application. In addition, although the terms used in this application are selected from well-known and commonly used terms, some terms mentioned in the specification of this application may be selected by the applicant based on his or her judgment, and their detailed meanings are set out in the relevant section of the description. Furthermore, the application is required to be understood not merely by the actual terms used, but also by the meaning connoted by each term.

The flow chart is used in this application to illustrate the operations performed by the system according to the embodiment of this application. It should be understood that the preceding or following operations are not necessarily performed in an exact order. Instead, various steps may be processed in reverse order or concurrently. And, other operations can either add to these procedures, or a certain step or steps can be removed from these procedures.

Next, a solar cell and a method of producing a solar cell of the present disclosure will be described in specific embodiments.

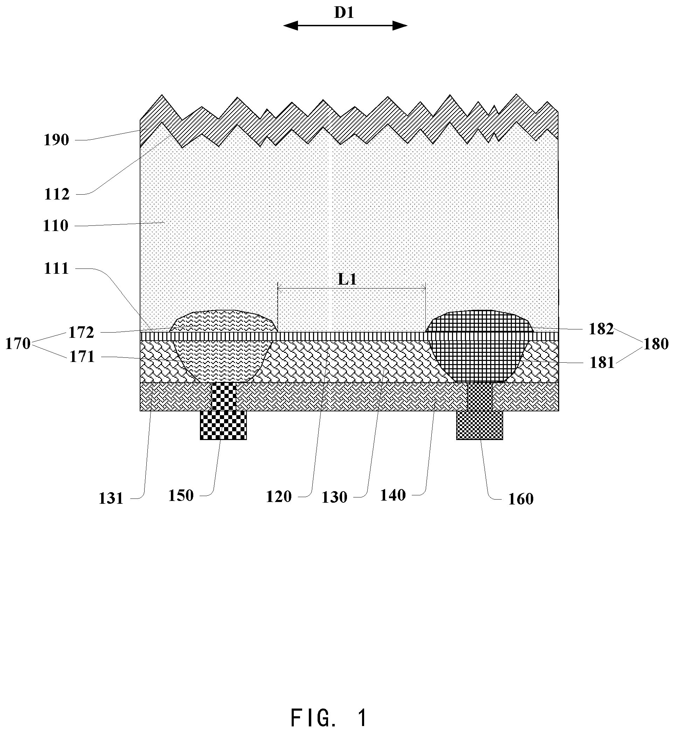

Referring to the schematic cross-sectional view of a solar cell in an embodiment shown in Fig. 1, the solar cell in the embodiment includes a silicon substrate 110, a tunneling layer 120, a polysilicon layer 130, a first electrode 150, a second electrode 160, a first doped region 170 and a second doped region 180.

Specifically, the silicon substrate 110 may be single crystal silicon or polycrystalline silicon, and the doping type of the silicon substrate 110 may be P-type or N-type. When the doping type of the silicon substrate 110 is P-type, the doping element may be one or more of boron (B), aluminum (Al), and gallium (Ga), and when the doping type is N-type, the doping element may be one or more of phosphorus (P), nitrogen (N) and arsenic (As).

The tunneling layer 120 and the polysilicon layer 130 are successively formed on a backside 111 of the silicon substrate 110. The tunneling layer 120 may include one or more of silicon dioxide (SiO₂), silicon nitride (SiNₓ), silicon oxynitride (SiOₓN_{y}) and aluminum oxide (Al₂O₃). The tunneling layer 120 has tunneling effect. The thickness of the tunneling layer 120 is not greater than 3.5 nm, for example, 1 nm, 1.5 nm, 2 nm, 2.5 nm or 3nm. When the thickness of the tunneling layer 120 exceeds 3.5 nm, the tunneling effect is poor.

The polysilicon layer 130 may be intrinsic polysilicon or doped polysilicon. When the polysilicon layer 130 is doped polysilicon, the doping element in the polysilicon layer 130 may be the same as the doping element in the silicon substrate 110, or it can also be different. In an embodiment, the polysilicon layer 130 may include one or more of oxygen (O), carbon (C), and nitrogen (N). For example, when the polysilicon layer 130 is doped polysilicon, the doping element in the polysilicon layer 130 includes the same doping element as the doping element in the silicon substrate 110, and one or more of oxygen, carbon, and nitrogen. For another example, when the polysilicon layer 130 is doped polysilicon, the doping element in the polysilicon layer 130 is one or more of oxygen, carbon, and nitrogen, and does not include the same doping element as the doping element in the silicon substrate 110. The present disclosure found that doping the polysilicon layer 130 with one or more of oxygen, carbon, and nitrogen has the following advantages: improving the passivation effect of the polysilicon layer 130 on solar cell and the selectivity of carriers, improving open circuit voltage and fill factor (FF), optically reducing the parasitic absorption loss of the polysilicon layer 130, thereby increasing the short-circuit current density of the solar cell.

In one embodiment, the thickness of the polysilicon layer 130 is 10~600 nm, for example, 100 nm, 200 nm, 300 nm, 400 nm, or 500 nm.

The silicon substrate 110 also has a front side 112, which is opposite to the backside 111. When the solar cell is working, the front side 112 faces the sun to receive sunlight. The front side 112 may have a pyramid texture. When the solar cell is working, sunlight is incident on the silicon substrate 110 from the side of the front side 112. The pyramid texture has the function of trapping light and reducing reflection, thereby improving the utilization of the sunlight of the solar cell.

In one embodiment, the solar cell further includes a passivation anti-reflection layer 190 on the front side 112. The passivation anti-reflection layer 190 may include one or more of SiNₓ, SiOₓN_{y}, SiO₂, and Al₂O₃. The thickness of the passivation anti-reflection layer 190 is no more than 150 nm, for example, 40 nm, 80 nm, or 120 nm. The passivation anti-reflection layer 190 has a passivation effect and an anti-reflection effect.

The dielectric layer 140 is formed on a backside 131 of the polysilicon layer 130. The dielectric layer 140 may include one or more of SiNₓ, SiOₓN_{y}, SiO₂, or Al₂O₃. For example, the dielectric layer 140 is stacked by a SiNₓ film and an Al₂O₃ film. The thickness of the dielectric layer 140 is no more than 200nm, for example, 50 nm, 100 nm, or 150 nm. The dielectric layer 140 has a passivation effect.

The first electrode 150 and the second electrode 160 are adjacently disposed on a backside of the dielectric layer 140 (i.e., a surface of the dielectric layer 140 away from the substrate). The first electrode 150 penetrates the dielectric layer 140 and is in contact with the polysilicon layer 130 at one end close to the silicon substrate 110, and the end of the first electrode 150 close to the silicon substrate 110 may be in contact with the backside 131 of the polysilicon layer 130 (that is, the surface of the polysilicon layer 130 away from the substrate), or may be deep into an inside of the polysilicon layer 130. Similarly, the second electrode 160 penetrates the dielectric layer 140 and is in contact with the polysilicon layer 130 at one end close to the silicon substrate 110. Wherein, the end of the second electrode 160 close to the silicon substrate 110 may be in contact with the backside 131 of the polysilicon layer 130, or may deep into an inside of the polysilicon layer 130.

The first doped region 170 starts from the first electrode 150 and extends to the inside of the silicon substrate 110. In other words, one end of the first doped region 170 away from the silicon substrate 110 is in contact with the first electrode 150, and one end of the first doped region 170 close to the silicon substrate 110 extends to the inside of the silicon substrate 110. The doping type of the first doped region 170 may be P-type or N-type.

Similarly, the second doped region 180 starts from the second electrode 160 and extends to the inside of the silicon substrate 110. In other words, one end of the second doped region 180 away from the silicon substrate 110 is in contact with the second electrode 160, and one end of the second doped region 180 close to the silicon substrate 110 extends to the inside of the silicon substrate 110. The doping type of the second doped region 180 may be P-type or N-type, and the doping type of the second doped region 180 is opposite to the doping type of the first doped region 170. For example, when the doping type of the first doped region 170 is P-type, the doping type of the second doped region 180 is N-type. The doping element used to form P-type doping can be one or more of boron element, aluminum and gallium, and the doping element used to form N-type doping can be one or more of phosphorus, nitrogen and arsenic.

The first electrode 150 contains the same doping element as the doping element in the first doped region 170, and the second electrode 160 contains the same doping element as the doping element in the second doped region 180. Specifically, it is assumed that the first doped region 170 is P-type doped, and the doping element used to form P-type doped is boron, the second doped region 180 is N-type doped, and the doping element used to form N-type doped is phosphorus, then the first electrode 150 contains boron, the second electrode 160 contains phosphorus.

In addition, the doping element in the first doped region 170 comes from the first electrode 150, and the doping element in the second doped region 180 comes from the second electrode 160. This is because the first doped region 170 is formed by the thermal diffusion of the doping element in the first electrode 150, and the second doped region 180 is formed by the thermal diffusion of the doping element in the second electrode 160. This will be described later.

Referring to Fig. 1, the first doped region 170 can be divided into a lower first doped region 171 and an upper first doped region 172 according to different locations. Wherein, the lower first doped region 171 is located in the polysilicon layer 130, which starts from the first electrode 150 and extends to the interface between the tunneling layer 120 and the polysilicon layer 130. The upper first doped region 172 is located in the silicon substrate 110, which starts from the interface between the tunneling layer 120 and the silicon substrate 110, and extends toward the inside of the silicon substrate 110. The tunneling layer 120 located between the lower first doped region 171 and the upper first doped region 172 contains the same doping element as the doping element in the first doped region 170.

Similarly, the second doped region 180 can be divided into a lower second doped region 181 and an upper second doped region 182 according to different locations. Wherein, the lower second doped region 181 is located in the polysilicon layer 130, which starts from the second electrode 160 and extends to the interface between the tunneling layer 120 and the polysilicon layer 130. The upper second doped region 182 is located in the silicon substrate 110, which starts from the interface between the tunneling layer 120 and the silicon substrate 110 and extends toward the inside of the silicon substrate 110. The tunneling layer 120 located between the lower second doped region 181 and the upper second doped region 182 contains the same doping element as the doping element in the second doped region 180.

In one embodiment, a width of the upper first doped region 172 is equal to or greater than a width of the lower first doped region 171, and the width of the lower first doped region 171 is equal to or greater than a width of a contact portion between the first electrode 150 and the polysilicon layer 130. Similarly, a width of the upper second doped region 182 is equal to or greater than a width of the lower second doped region 181, and a width of the lower second doped region 181 is equal to or greater than a width of the contact portion between the second electrode 160 and the polysilicon layer 130. The above-mentioned width refers to the maximum width, for example, "a width of the upper first doped region 172" refers to "a maximum width of the upper first doped region 172".

Referring to Fig. 1, in one embodiment, the minimum distance L1 between the first doped region 170 and the second doped region 180 in the first direction D1 is equal to or greater than 30 µm, for example, 35 µm, 40 µm, 45 µm, or 50 µm. The polysilicon layer 130 located between the first doped region 170 and the second doped region 180 in the first direction D1 can isolate the first doped region 170 from the second doped region 180, thereby preventing the current transmission between the first doped region 170 and the second doped region 180 through the polycrystalline silicon layer 130 between the two, preventing short-circuit current from occurring between the first doped region 170 and the second doped region 180, then improving the efficiency of the solar cell. In order to obtain the above technical effects, the polysilicon layer 130 should be nonconductive or have a high resistance, for example, the polysilicon layer 130 is intrinsic polysilicon. It should be noted that due to factors such as limitations of the process steps themselves, there may be situations where doping element diffuses into intrinsic polysilicon. For example, the doping element in the silicon substrate 110 diffuses into intrinsic polysilicon. In this case, the polysilicon layer 130 is doped polysilicon and is no longer intrinsic polysilicon. However, because the concentration of doping element in the polysilicon layer 130 is very low and almost negligible, the polysilicon layer 130 located between the first doped region 170 and the second doped region 180 can still prevent (or reduce) current transmission between the doped region 170 and the second doped region 180. In addition, in order to ensure that there is no current transmission between the first doped region 170 and the second doped region 180, the above embodiment defines that the minimum distance L1 between the first doped region 170 and the second doped region 180 is equal to or greater than 30 µm.

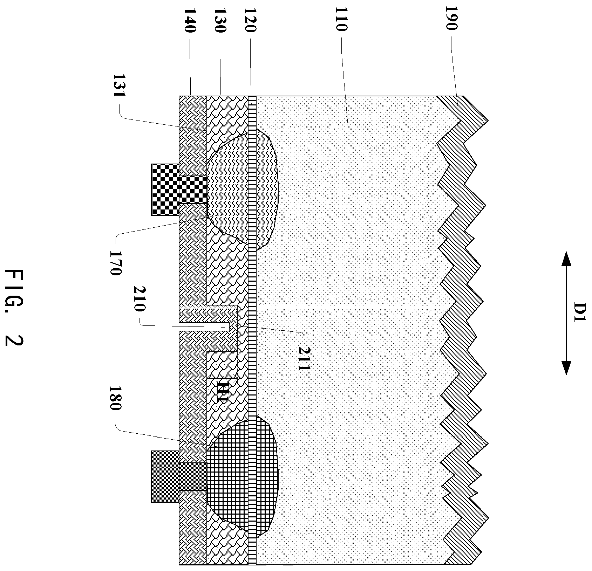

Fig. 2 is a schematic cross-sectional view of a solar cell in another embodiment. The main difference between Fig. 2 and Fig. 1 is that the solar cell in Fig. 2 has an isolation groove 210. Specifically, the isolation groove 210 is located between the first doped region 170 and the second doped region 180 in the first direction, and the isolation groove 210 at least deeps into the polysilicon layer 130 to a predetermined depth H1. The predetermined depth H1 refers to the distance between the bottom 211 and the backside 131 of the polysilicon layer 130. The dielectric layer 140 in Fig. 2 covers the bottom 211 and the sidewall of the isolation groove 210.

In Fig. 2, the bottom 211 of the isolation groove 210 is flat. In other embodiments, the bottom 211 may have a pyramid texture.

Next, the depth of the isolation groove 210 will be described. In Fig. 2, the isolation groove 210 deeps into the polysilicon layer 130, that is, the bottom 211 is located in the polysilicon layer 130. As mentioned above, the polysilicon layer 130 located between the first doped region 170 and the second doped region 180 has the function of preventing current transmission between the first doped region 170 and the second doped region 180. However, there may be cases where the doping element diffuses into the polysilicon layer 130. In order to ensure that there is no current transmission between the first doped region 170 and the second doped region 180, this disclosure disposes the isolation groove 210 between the first doped region 170 and the doped region 180. The isolation groove 210 deeps into the polysilicon layer 130, thereby preventing current from being transmitted between the first doped region 170 and the second doped region 180 through the polysilicon layer 130.

It should be noted that in Fig. 2, the isolation groove 210 does not penetrate the polysilicon layer 130, and there is still a certain thickness of the polysilicon layer 130 between the bottom 211 and the tunneling layer 120. Since the polysilicon layer 130 between the bottom 211 and the tunneling layer 120 is very thin, it is difficult for current to pass through. In some embodiments, the predetermined depth H1 is equal to or greater than half the thickness of the polysilicon layer 130, and in this way, the thickness of the polysilicon layer 130 between the bottom 211 and the tunneling layer 120 can be reduced, thereby ensuring there is no current transmission between the first doped region 170 and the second doped region 180, or the current is very small.

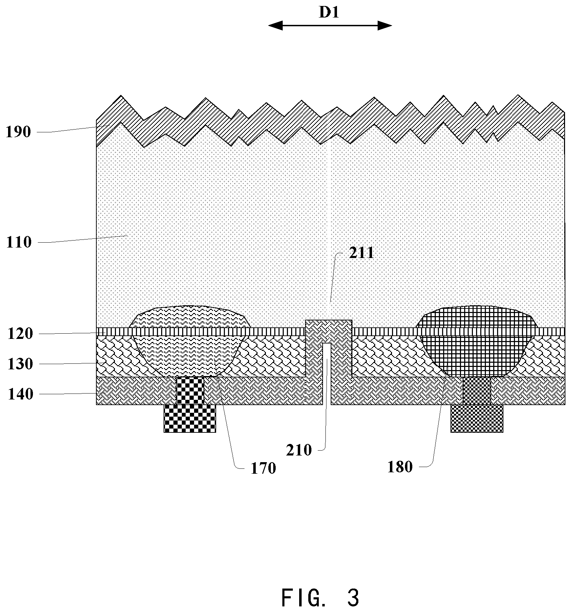

Referring to Fig. 3, the isolation groove 210 may also penetrate the polysilicon layer 130 and the tunneling layer 120, and the bottom 211 deeps into the silicon substrate 110. Since the isolation groove 210 penetrates the polysilicon layer 130, the first doped region 170 and the second doped region 180 cannot transmit current through the polysilicon layer between the two. Even if the doping concentration in the polysilicon layer 130 is high, current cannot be transmitted between the first doped region 170 and the second doped region 180 through the polysilicon layer 130 between the two, and this is because the isolation groove 210 completely breaks the polysilicon layer 130 between the first doped region 170 and the second doped region 180. In some other embodiments, the isolation groove 210 may not penetrate the tunneling layer 120 but penetrates the polysilicon layer 130.

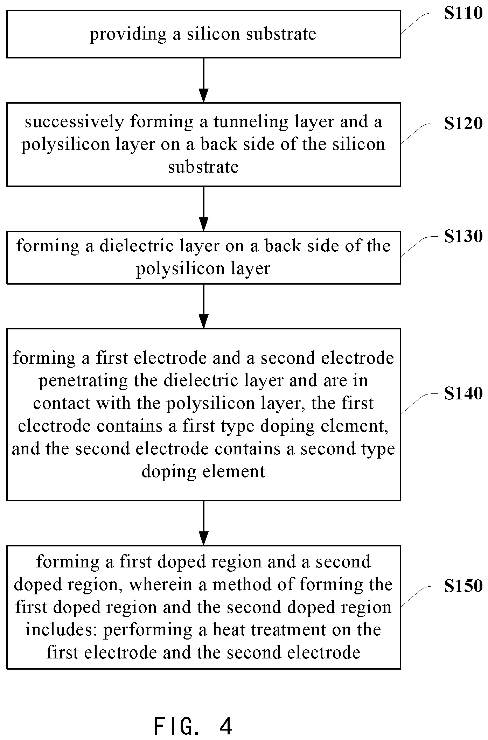

The present disclosure also proposes a method of producing a solar cell. Referring to the schematic flow chart of a method of producing a solar cell in an embodiment shown in Fig. 4, the method in this embodiment includes the following steps,
Step S110: providing a silicon substrate;
Step S 120: successively forming a tunneling layer and a polysilicon layer on a backside of the silicon substrate;
Step S130: forming a dielectric layer on a backside of the polysilicon layer;
Step S140: forming a first electrode and a second electrode penetrating the dielectric layer and are in contact with the polysilicon layer, the first electrode contains a first type doping element, and the second electrode contains a second type doping element;
Step S150: forming a first doped region and a second doped region, wherein a method of forming the first doped region and the second doped region includes: performing a heat treatment on the first electrode and the second electrode.

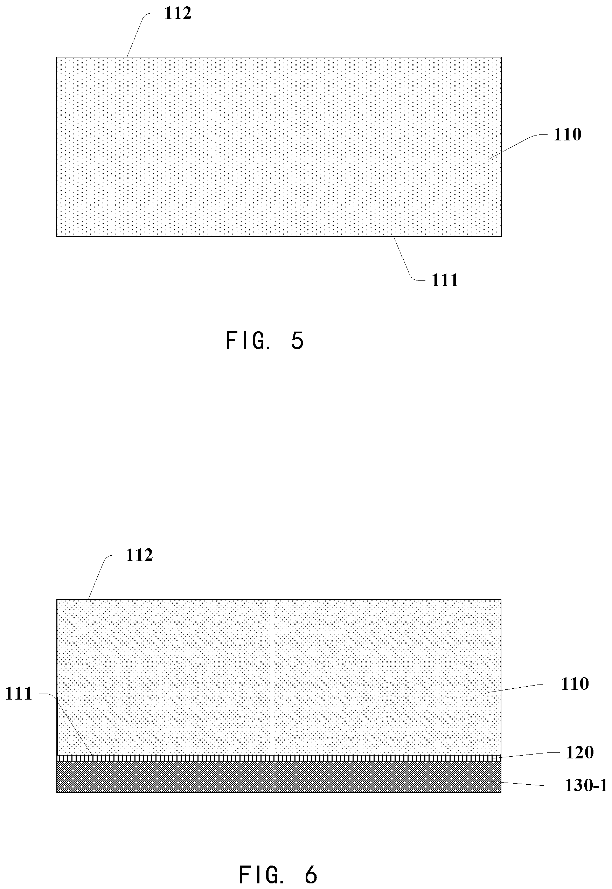

Figs. 5 to 12 are schematic cross-sectional views of intermediate products during the process of producing a solar cell according to the method of producing a solar cell in an embodiment. Next, steps S110 to S150 will be described with reference to Figs. 5 to 12.

Referring to Fig. 5, in step S110, a silicon substrate 110 is provided, and the silicon substrate 110 has a backside 111 and a front side 112 opposite to each other.

Referring to Figs. 5 to 7, in step S120, a tunneling layer 120 and a polysilicon layer 130 are successively formed on the backside 111 of the silicon substrate 110. The tunneling layer 120 includes one or more of SiNₓ, SiOₓN_{y}, SiO₂, and Al₂O3. The method of forming the tunneling layer 120 includes plasma enhanced chemical vapor deposition (PECVD) and atomic layer deposition (ALD).

In one embodiment, the method of forming the polysilicon layer 130 includes the following steps: first, forming an amorphous silicon layer 130-1 on the backside of the tunneling layer 120; then, crystallizing the amorphous silicon layer 130-1 to convert amorphous silicon layer 130-1 into polysilicon layer 130. The crystallizing method includes thermal oxidation. During the thermal oxidation, a first corrosion-resistant layer 221 is formed on the front side 112 of the silicon substrate 110 and a second corrosion-resistant layer 222 is formed on the backside 131 of the polysilicon layer 130. The first corrosion-resistant layer 221 is a silicon oxide (SiOₓ) layer formed by oxidation of the silicon substrate with a certain thickness at the front side 112, and the second corrosion-resistant layer 222 is a silicon oxide (SiOₓ) layer by oxidation of the polycrystalline silicon layer with a certain thickness at the backside 131. In some other embodiments, the first corrosion-resistant layer 221 may also include one or more of a silicon oxide layer, a silicon nitride layer, and an aluminum oxide layer. For example, the first corrosion-resistant layer 221 is a composite layer composed of the silicon nitride layer and the aluminum oxide layer. Similarly, the first corrosion-resistant layer 222 may also include one or more of a silicon oxide layer, a silicon nitride layer, and an aluminum oxide layer. For example, the first corrosion-resistant layer 222 is a composite layer composed of the silicon nitride layer and the aluminum oxide layer.

The polysilicon layer 130 includes intrinsic polysilicon or doped polysilicon. When the polysilicon layer 130 is doped polysilicon, the reason for forming the doped polysilicon may be that during the crystallization process of the amorphous silicon layer 130-1, the doping element in the silicon substrate 110 diffuses into the amorphous silicon layer 130-1, and after the crystallization process, the amorphous silicon containing doping element is converted into doped polysilicon. It should be noted that during the crystallization process, the doping element in the silicon substrate 110 does not necessarily diffuse into the amorphous silicon layer 130-1. In some embodiments, the polysilicon layer 130 may include one or more of oxygen, carbon, and nitrogen.

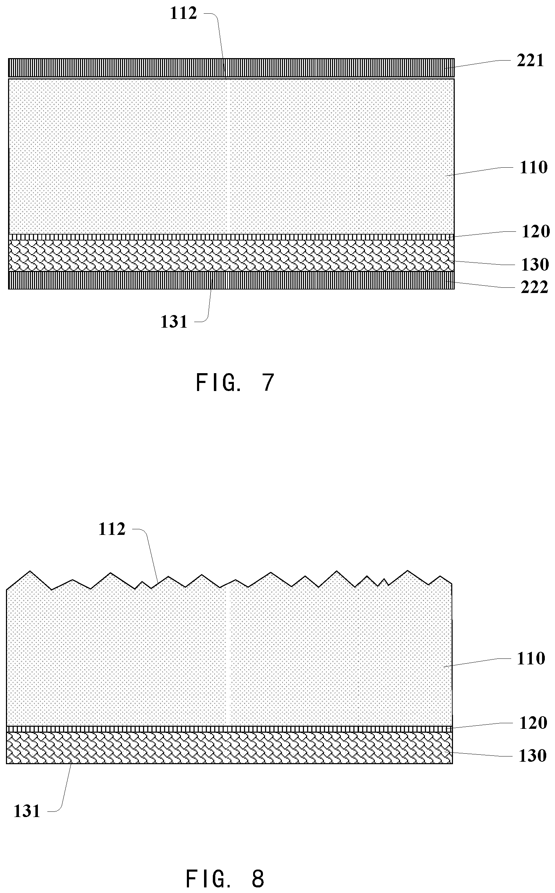

Referring to Figs. 7 to 9, in step S130, a dielectric layer 140 is formed on the backside 131 of the polysilicon layer 130. The dielectric layer 140 may include one or more of SiNₓ, SiOₓN_{y}, SiO₂, or Al₂O₃. The dielectric layer 140 may contain hydrogen (H), and the hydrogen may come from the raw material used to form the dielectric layer 140.

In one embodiment, before performing step S130, the method further includes: performing a texturing process on the front side 112 so that the front side 112 has a pyramid texture. The second corrosion-resistant layer 222 in Fig. 7 can be used to protect the polysilicon layer 130 from etching during the texturing process. Specifically, the chemical liquid (such as an alkaline chemical liquid) used in the texturing process has an etching effect on polysilicon but has no etching effect or weak etching effect on the second corrosion-resistant layer 222. Therefore, the second corrosion-resistant layer 222 can protect the polysilicon layer 130 from etching. It should be noted that in Fig. 7, no corrosion-resistant layer is formed on the side of the silicon substrate 110 and the side of the polysilicon layer 130 because Fig. 7 is a cross-sectional view of a partial structure.

In one embodiment, after the crystallization process is performed on the amorphous silicon layer 130-1 and before the texturing process, the dielectric layer is formed on a side of the polysilicon layer 130 away from the silicon substrate 110, that is, the dielectric layer 140 is formed on the backside of the second corrosion-resistant layer 222. In this way, during the texturing process, the dielectric layer 140 and the second corrosion-resistant layer 222 together protect the polysilicon layer 130 from being etched by the chemical liquid.

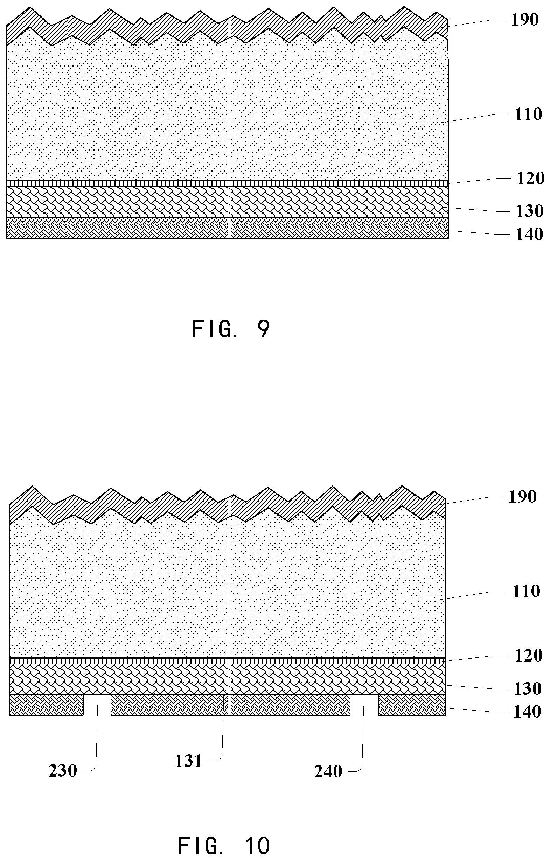

Referring to Figs. 8 and 9, in one embodiment, a passivation anti-reflection layer 190 may also be formed on the front side 112 of the silicon substrate 110.

Referring to Figs. 10 to 12, in step S140, a first electrode 150 and a second electrode 160 penetrating the dielectric layer 140 and in contact with the polysilicon layer 130 are formed. The first electrode 150 has a first type doping element, and the second electrode 160 has a second type doping element.

Specifically, as shown in Fig. 9 and Fig. 10, the dielectric layer 140 is subjected to a hole opening process to form a first opening 230 and a second opening 240. The first opening 230 and the second opening 240 expose the polysilicon layer 130. In Fig. 10, the first opening 230 deeps into the interface between the polysilicon layer 130 and the dielectric layer 140, and the second opening 240 also deeps into the interface between the polysilicon layer 130 and the dielectric layer 140. In other words, the first opening 230 and the second opening 240 expose the backside 131 of the polysilicon layer 130. In some other embodiments, the first opening 230 may also deep into the polysilicon layer 130, and the first opening 230 may also be deeps into the polysilicon layer 130. The first opening 230 may be a point opening or a line opening, and the second opening 240 may be a point opening or a line opening. "Point opening" refers to the opening in the shape of a point looking upward from the bottom of Fig. 10, for example, the point shape can be a circular point shape or a rectangular point shape; "line opening" refers to the opening in the shape of a long strip looking upward from the bottom of Fig.10.

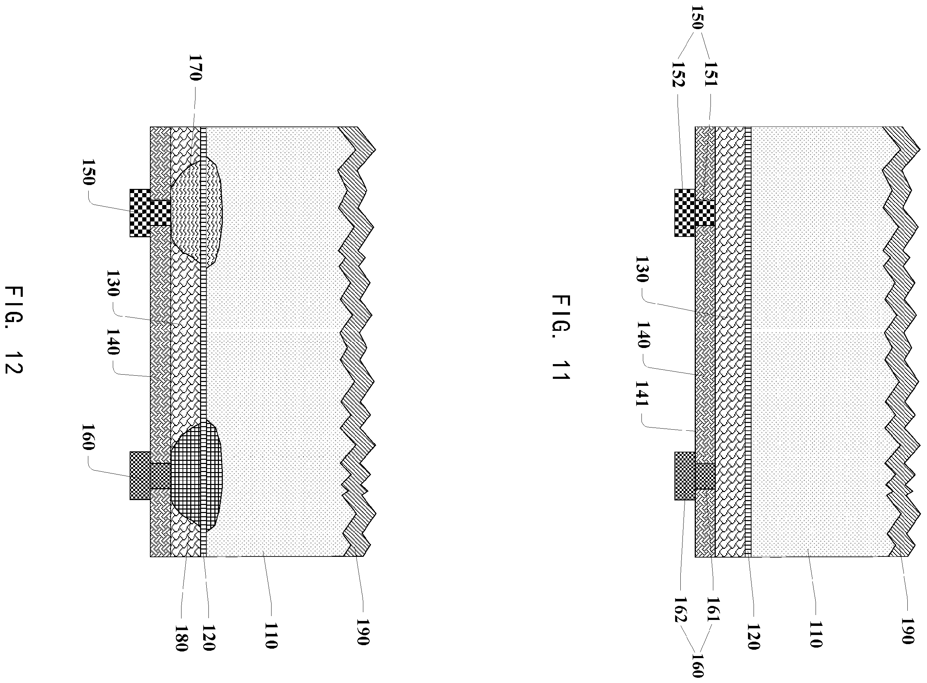

Next, referring to Fig. 10 and Fig. 11, the first electrode 150 is formed in the first opening 230 and the second electrode 160 is formed in the second opening 240. In one embodiment, the first electrode 150 includes an upper first electrode 151 and a lower first electrode 152, the upper first electrode 151 is located in the first opening 230 and is in contact with the polysilicon layer 130, the lower first electrode 152 is in contact with the upper first electrode 151 and is located on the backside 141 of the dielectric layer 140. The second electrode 160 includes an upper second electrode 161 and a lower second electrode 162, the upper second electrode 161 is located in the second opening 240 and is in contact with the polysilicon layer 130, the lower second electrode 162 is in contact with the upper second electrode 161, and is located on the backside 141 of the dielectric layer 140.

Referring to Fig. 11 and Fig. 12, in step S150, a first doped region 170 and a second doped region 180 are formed. Specifically, as mentioned above, the first electrode 150 contains a first type doping element, and the first type doping element may be a P-type doping element or an N-type doping element. The second electrode 160 contains a second type doping element, and the second type doping element may be a P-type doping element or an N-type doping element. The doping type of the first type doping element is opposite to the doping type of the second type doping element. In other words, when the first type doping element is a P-type doping element, then the second type doping element is N-type doping element, when the first type doping element is an N-type doping element, the second type doping element is a P-type doping element.

Performing heat treatment on the first electrode 150 to diffuse the first type doping element in the first electrode 150 into the polysilicon layer 130 and the silicon substrate 110, thereby forming the first doped region 170. Similarly, performing heat treatment on the second electrode 160 to diffuse the second type doping element in the second electrode 160 into the polysilicon layer 130 and the silicon substrate 110, thereby forming the second doped region 180. The above heat treatment includes heat treatment by using a laser.

Referring to Fig. 12, the first doped region 170 starts from the first electrode 150 and extends to the inside of the silicon substrate 110, and the second doped region 180 starts from the second electrode 160 and extends to the inside of the silicon substrate 110. In one embodiment, the width of the first doped region located in the silicon substrate 110 is equal to or greater than the width of the first doped region located in the polysilicon layer 130, and the width of the first doped region located in the polysilicon layer 130 is equal to or greater than the width of the contact portion between the first electrode 150 and the polysilicon layer 130. Similarly, the width of the second doped region located in the silicon substrate 110 is equal to or greater than the width of the second doped region located in the polysilicon layer 130, and the width of the second doped region located in the polysilicon layer 130 is equal to or greater than the width of the contact portion between the second electrode 160 and the polysilicon layer 130. In the embodiment, the minimum distance between the first doped region 170 and the second doped region 180 is equal to or greater than 30 µm. For other descriptions of this part, please refer to the relevant parts in the previous specification, which will not be elaborated here.

Referring to Figs. 12, in one embodiment, the method of the present disclosure further includes: hydrogenating the solar cell. Specifically, the dielectric layer 140 is annealed so that the hydrogen in the dielectric layer 140 diffuses into the inside of the silicon substrate 110. During the annealing process, the hydrogen in the dielectric layer 140 diffuses into the polysilicon layer 130 and the tunneling layer 120, and further diffuses into the silicon substrate 110. The hydrogen can neutralize defects in the polysilicon layer 130 and defects in the silicon substrate 110, thereby reducing carrier recombination. As mentioned above, the dielectric layer 140 of the present disclosure contains hydrogen. Therefore, when hydrogenating the dielectric layer 140, no additional hydrogen source (such as a gas containing hydrogen element) is required, and this saves costs incurred by additional hydrogen sources.

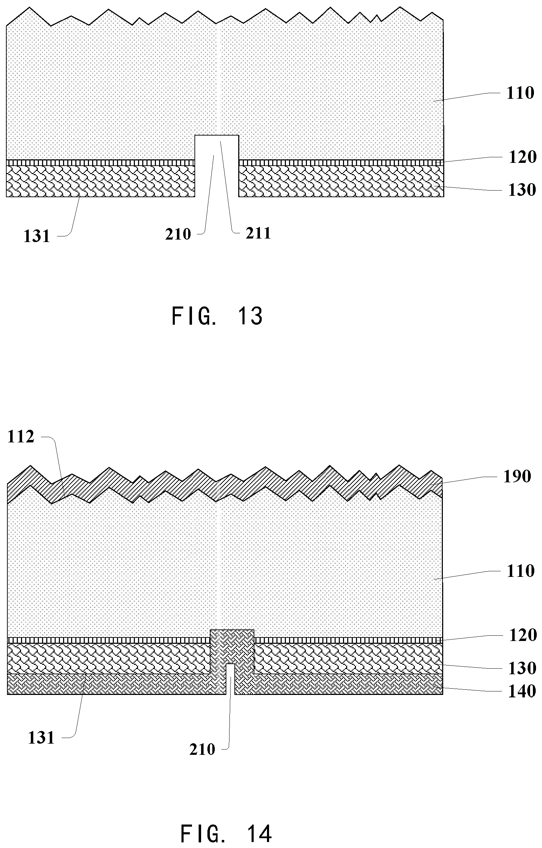

Figs. 13 to 17 are schematic cross-sectional views of intermediate products during the process of producing a solar cell according to a method of producing a solar cell in another embodiment. Wherein, the process steps before Fig. 13 are similar to Figs. 5 to 7, and for related content, please refer to Figs. 5 to Fig. 7. Referring to Figs. 13 to 17, before forming the dielectric layer 140, an isolation groove 210 is formed between the first doped region 170 and the second doped region 180, wherein the isolation groove 210 deeps into the polysilicon layer at least as deep as a predetermined depth.

Specifically, referring to Fig. 13, forming the isolation groove 210 which penetrates the polysilicon layer 130 and the tunneling layer 120, and the bottom 211 of the isolation groove 210 is located in the silicon substrate 110. In some other embodiments, the isolation groove 210 may not penetrate the tunneling layer 120, but only penetrates the polysilicon layer 130, and the isolation groove 210 may also not penetrate the polysilicon layer 130, but deeps into the polysilicon layer 130 with a predetermined depth. For details about this part, please refer to the previous specification, which will not be elaborated here.

Referring to Figs. 13 and 14, a dielectric layer 140 is formed. The dielectric layer 140 covers the backside 131 of the polysilicon layer 130 and the bottom and side of the isolation groove 210. A passivation anti-reflection layer 190 may also be formed on the front side 112 of the silicon substrate 110.

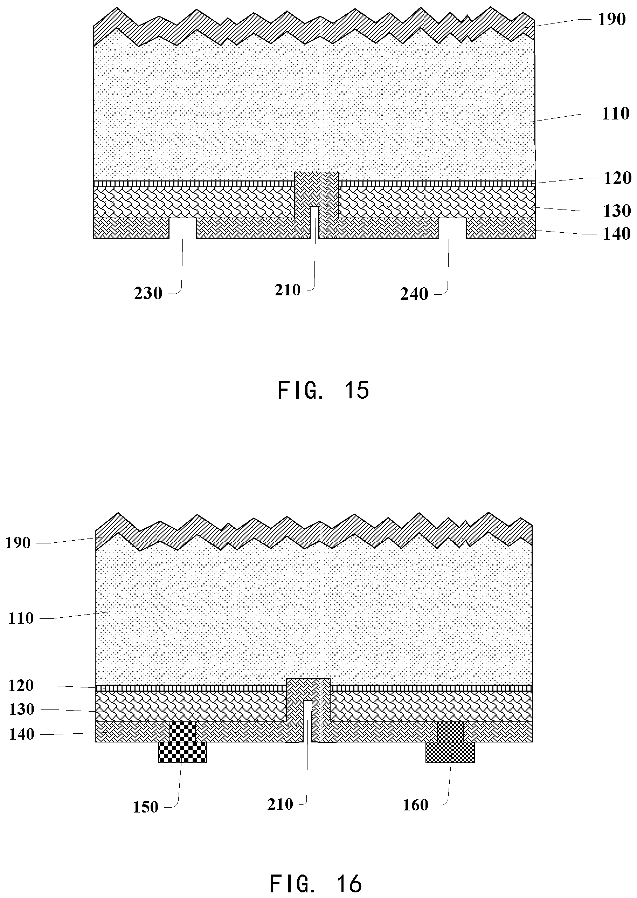

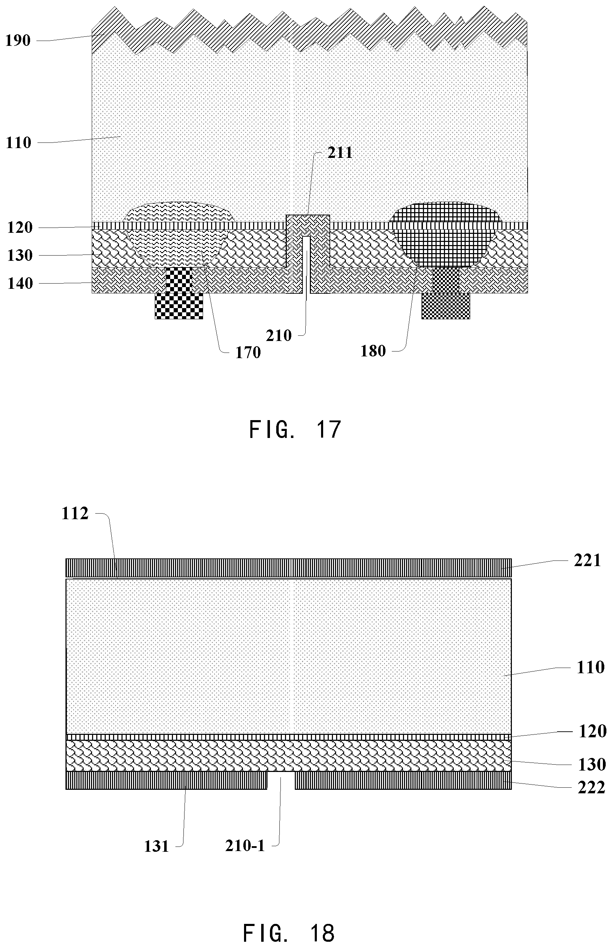

Referring to Fig. 15, it forms a first opening 230 and a second opening 240 which penetrate the dielectric layer 140. Both the first opening 230 and the second opening 240 expose the polysilicon layer 130. Referring to Figs. 15 to 17, a first electrode 150 is formed in the first opening 230 and a second electrode 160 is formed in the second opening 240. Referring to Fig. 16 and Fig. 17, it performs heat treatment on the first electrode 150 to form a first doped region 170, and it performs heat treatment on the second electrode 160 to form a second doped region 180. For details of Figs. 15 to 17, please refer to the previous description of Figs. 10 to 12, which will not be elaborated here.

The method of forming the isolation groove is not limited to the above embodiment. Here is a method of forming an isolation groove in another embodiment.

First, as shown in Fig. 18, an initial isolation groove 210-1 is formed. The initial isolation groove 210-1 penetrates the second corrosion-resistant layer 222 and exposes the polysilicon layer 130. Initial isolation groove 210-1 may be formed using a laser. It can be understood that the initial isolation groove 210-1 is located between the first doped region and the second doped region that will be formed in subsequent process steps.

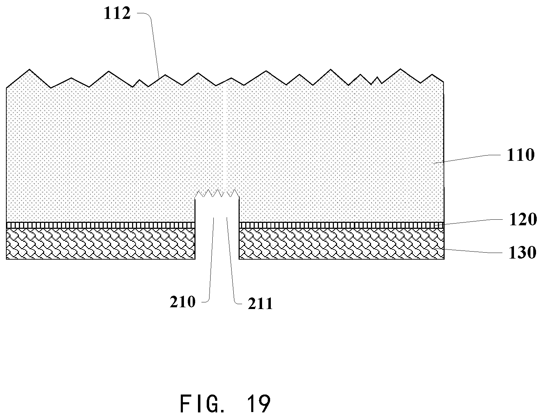

Next, as shown in Fig. 19, a texturing process is performed on the front side 112 of the silicon substrate 110. During the texturing process, the polysilicon layer 130 exposed by the initial isolation groove 210-1 will be etched. For example, it is etched by the chemical liquid used in the texturing process step, thereby increasing the depth of the initial isolation groove 210-1, and finally obtaining the isolation groove 210.

During the process of using a laser to form the initial isolation groove 210-**1,** the laser may cause damage to the polysilicon layer 130 exposed by the initial isolation groove 210-1. Similarly, if a laser is used to directly form the isolation groove 210, the laser will cause damage to the polysilicon layer 130 exposed by the isolation groove 210. When the solar cell is operating, the damage caused by the laser will become a recombination center of carriers, resulting in a decrease in the efficiency of the solar cell. In order to eliminate the damage caused by the laser to the polysilicon layer 130, this disclosure first forms the initial isolation groove 210-1, and then etches the initial isolation groove 210-1 through the chemical liquid used in the texturing process step. In this way, the chemical liquid etches away the damage caused by the laser to the polysilicon layer 130 while increasing the depth of the initial isolation groove 210-1, thereby eliminating the damage caused by the laser to the polysilicon layer 130, and improving the efficiency of the solar cell. In addition, there is another advantage of forming the isolation groove 210 by etching the initial isolation groove 210-1 with the chemical liquid used in the texturing process step: compared with directly forming the isolation groove 210 by using a laser, the above method of forming the isolation groove 210 can reduce the laser operating time because the depth of the initial isolation groove 210-1 is less than the depth of isolation groove 210. In this way, the method of forming the isolation groove 210 in the above method can also reduce the laser cost and shorten the time for forming the isolation groove 210.

As shown in Fig. 9, Fig. 18, and Fig. 19, in some embodiments, the dielectric layer 140 may be formed on the backside of the second corrosion-resistant layer 222 before texturing the front side 112. Specifically, the dielectric layer 140 may be formed before the initial isolation groove 210-1 is formed. In this case, the initial isolation groove 210-1 penetrates the dielectric layer 140 and the second corrosion-resistant layer 222; and the dielectric layer 140 may be formed on the backside of the second corrosion-resistant layer 222 after the formation of the initial isolation groove 210-1 and before texturing the front side 112.

Referring to Fig. 19, the bottom 211 of the isolation groove 210 has a pyramid texture. This is because when the front side 112 is subjected to the texturing process, the silicon substrate 110 exposed by the bottom 211 is also subjected to the texturing process.

The basic concepts have been described above. Obviously, for those skilled in the art, the above application disclosures are only examples and do not constitute limitations to the present application. Although not explicitly stated herein, those skilled in the art may make various modifications, improvements, and corrections to this application. Such modifications, improvements and corrections are suggested in this application, so such modifications, improvements and corrections still fall within the scope of the exemplary embodiments of this application.

Meanwhile, this application uses specific words to describe the embodiments of the application. For example, "one embodiment", "an embodiment", and/or "some embodiments" means a certain feature, structure or characteristic related to at least one embodiment of the present application. Therefore, it should be emphasized and noted that "one embodiment" or "an embodiment" or "an alternative embodiment" mentioned twice or more at different places in this specification does not necessarily refer to the same embodiment. In addition, certain features, structures or characteristics in one or more embodiments of the present application may be appropriately combined.

Similarly, it should be noted that, in order to simplify the presentation of the disclosure of the present application and thereby facilitate understanding of one or more embodiments of the present application, in the foregoing description of the embodiments of the present application, multiple features are sometimes combined into one embodiment. accompanying drawings or descriptions thereof. However, this method of disclosure does not imply that the subject matter of the application requires more features than are mentioned in the claims. In fact, embodiments may have less than all features of a single disclosed embodiment.

In some embodiments, numbers are used to describe the quantities of components and properties. It should be understood that such numbers used to describe the embodiments are modified by the modifiers "about", "approximately" or "substantially" in some examples. Unless otherwise stated, "about", "approximately" or "substantially" means that the stated number is allowed to vary by ±20%. Accordingly, in some embodiments, the numerical parameters used in the specification and claims are approximations that may vary depending on the desired features of the individual embodiment. In some embodiments, numerical parameters should account for the specified number of significant digits and use general digit preservation methods. Although the numerical fields and parameters used to confirm the breadth of the ranges in some embodiments of the present application are approximations, in specific embodiments, such numerical values are set as accurately as feasible.

## Claims

1. A solar cell, comprising:
a silicon substrate (110);
a tunneling layer (120) and a polysilicon layer (130) successively formed on a backside of the silicon substrate;
a dielectric layer (140) formed on a backside (131) of the polysilicon layer;
a first electrode (150) and a second electrode (160), the first electrode and the second electrode penetrate the dielectric layer and are in contact with the polysilicon layer;
a first doped region (170) and a second doped region (180), the first doped region starts from the first electrode and extends to an inside of the silicon substrate, and the second doped region starts from the second electrode and extends to the inside of the silicon substrate, and
an isolation groove (210) located between the first doped region and the second doped region, and the isolation groove deeps into the polysilicon layer at least as deep as a predetermined depth,
**characterized in that**
the first electrode contains a doping element same as a doping element in the first doped region, and the second electrode contains a doping element same as a doping element in the second doped region.

2. The solar cell according to claim 1, **characterized in that**, the tunneling layer includes one or more of silicon dioxide, silicon nitride, silicon oxynitride and aluminum oxide, and the polysilicon layer includes intrinsic polysilicon.

3. The solar cell according to claim 1, **characterized in that**, a width of the first doped region located in the silicon substrate is equal to or greater than a width of the first doped region located in the polysilicon layer, and the width of the first doped region located in the polysilicon layer is equal to or greater than a width of a contact portion between the first electrode and the polysilicon layer, and/or a width of the second doped region in the silicon substrate is equal to or greater than a width of the second doped region located in the polysilicon layer, and the width of the second doped region located in the polysilicon layer is equal to or greater than a width of a contact portion between the second electrode and the polysilicon layer.

4. The solar cell according to claim 1, **characterized in that**, the dielectric layer covers a bottom and a sidewall of the isolation groove, and/or the dielectric layer includes one or more of silicon dioxide, silicon nitride, silicon oxynitride, and aluminum oxide.

5. The solar cell according to claim 1, **characterized in that**, the predetermined depth is equal to or greater than half of a thickness of the polysilicon layer, or the isolation groove penetrates the polysilicon layer, or the isolation groove penetrates the polysilicon layer and the tunneling layer.

6. A method of producing a solar cell, **characterized by** comprising:
providing a silicon substrate (S110);
successively forming a tunneling layer and a polysilicon layer on a backside of the silicon substrate (S120);
forming a dielectric layer on a backside of the polysilicon layer (S130);
forming a first electrode and a second electrode penetrating the dielectric layer and in contact with the polysilicon layer, the first electrode contains a first type doping element, and the second electrode contains a second type doping element (S140); and
forming a first doped region and a second doped region, wherein a method of forming the first doped region and the second doped region includes: performing a heat treatment on the first electrode and the second electrode (S150).

7. The method according to claim 6, **characterized in that**, the dielectric layer contains hydrogen, preferably, annealing the dielectric layer to diffuse the hydrogen in the dielectric layer to the polysilicon layer, the tunneling layer, and the silicon substrate.

8. The method according to claim 6, **characterized in that**, the first doped region starts from the first electrode and extends to an inside of the silicon substrate, and the second doped region starts from the second electrode and extends to the inside of the silicon substrate.

9. The method according to claim 8, **characterized in that**, a width of the first doped region located in the silicon substrate is equal to or greater than a width of the first doped region located in the polysilicon layer, and the width of the first doped region located in the polysilicon layer is equal to or greater than a width of a contact portion between the first electrode and the polysilicon layer, and/or a width of the second doped region located in the silicon substrate is equal to or greater than a width of the second doped region located in the polysilicon layer, and the width of the second doped region located in the polysilicon layer is equal to or greater than a width of a contact portion between the first electrode, and the polysilicon layer.

10. The method according to claim 9, **characterized in that**, the tunneling layer includes one or more of silicon dioxide, silicon nitride, silicon oxynitride, and aluminum oxide, and the polysilicon layer includes intrinsic polysilicon.

11. The method according to claim 10, **characterized in that**, a minimum distance between the first doped region and the second doped region is equal to or greater than 30 µm.

12. The method according to claim 6, **characterized in that**, the polysilicon layer includes one or more of oxygen, carbon and nitrogen.

13. The method according to claim 6, **characterized in that**, before forming the dielectric layer, forming an isolation groove between the first doped region and the second doped region, wherein the isolation groove deeps into the polysilicon layer at least as deep as a predetermined depth, preferably the dielectric layer covers a bottom and a sidewall of the isolation groove.

14. The method according to claim 13, **characterized in that**, a method of forming the isolation groove includes:
forming an initial isolation groove penetrating a corrosion-resistant layer, and the initial isolation groove exposes the polysilicon layer, the corrosion-resistant layer includes one or more layers of a silicon oxide layer, a silicon nitride layer, and an aluminum oxide layer; and
performing a texturing process on a front side of the silicon substrate, and the texturing process etches the polysilicon layer exposed by the initial isolation groove to form the isolation groove;
preferably before performing the texturing process on the front side of the silicon substrate, forming the dielectric layer on a backside of the corrosion-resistant layer.

15. The method according to claim 14, **characterized in that**, a bottom of the isolation groove has a pyramid texture.

16. The method according to claim 6, **characterized in that**, a method of forming the polysilicon layer includes:
forming an amorphous silicon layer on a backside of the tunneling layer; and
crystallizing the amorphous silicon layer to convert the amorphous silicon layer into the polysilicon layer;
preferably, after crystallizing the amorphous silicon layer and before performing a texturing process on the front side of the silicon substrate, forming the dielectric layer on a side of the polysilicon layer away from the silicon substrate.

## Patentansprüche

1. Solarzelle, umfassend:
ein Siliziumsubstrat (110);
eine Tunnelschicht (120) und eine Polysilikonschicht (130), die nacheinander auf einer Rückseite des Siliziumsubstrats ausgebildet sind;
eine dielektrische Schicht (140), die auf einer Rückseite (131) der Polysilikonschicht ausgebildet ist;
eine erste Elektrode (150) und eine zweite Elektrode (160), wobei die erste Elektrode und die zweite Elektrode die dielektrische Schicht durchdringen und mit der Polysilikonschicht in Kontakt stehen;
einen ersten dotierten Bereich (170) und einen zweiten dotierten Bereich (180), wobei der erste dotierte Bereich von der ersten Elektrode ausgeht und sich bis in ein Inneres des Siliziumsubstrats erstreckt, und der zweite dotierte Bereich von der zweiten Elektrode ausgeht und sich bis in das Innere des Siliziumsubstrats erstreckt, und
eine Isolationsnut (210), die zwischen dem ersten dotierten Bereich und dem zweiten dotierten Bereich angeordnet ist, und die Isolationsnut in die Polysilikonschicht mindestens bis zu einer vorbestimmten Tiefe eindringt,
**dadurch gekennzeichnet, dass**
die erste Elektrode ein Dotierelement enthält, das mit einem Dotierelement in dem ersten dotierten Bereich identisch ist, und die zweite Elektrode ein Dotierelement enthält, das mit einem Dotierelement in dem zweiten dotierten Bereich identisch ist.

2. Solarzelle nach Anspruch 1, **dadurch gekennzeichnet, dass** die Tunnelschicht eines oder mehrere von Siliziumdioxid, Siliziumnitrid, Siliziumoxynitrid und Aluminiumoxid umfasst, und die Polysilikonschicht intrinsisches Polysilizium umfasst.

3. Solarzelle nach Anspruch 1, **dadurch gekennzeichnet, dass** eine Breite des ersten dotierten Bereichs, der in dem Siliziumsubstrat angeordnet ist, gleich oder größer als eine Breite des ersten dotierten Bereichs ist, der in der Polysilikonschicht angeordnet ist, und die Breite des ersten dotierten Bereichs, der in der Polysilikonschicht angeordnet ist, gleich oder größer als eine Breite eines Kontaktbereichs zwischen der ersten Elektrode und der Polysilikonschicht ist, und/oder eine Breite des zweiten dotierten Bereichs in dem Siliziumsubstrat gleich oder größer als eine Breite des zweiten dotierten Bereichs ist, der in der Polysilikonschicht angeordnet ist, und die Breite des zweiten dotierten Bereichs, der in der Polysilikonschicht angeordnet ist, gleich oder größer als eine Breite eines Kontaktbereichs zwischen der zweiten Elektrode und der Polysilikonschicht ist.

4. Solarzelle nach Anspruch 1, **dadurch gekennzeichnet, dass** die dielektrische Schicht einen Boden und eine Seitenwand der Isolationsnut bedeckt, und/oder die dielektrische Schicht eines oder mehrere von Siliziumdioxid, Siliziumnitrid, Siliziumoxynitrid und Aluminiumoxid umfasst.

5. Solarzelle nach Anspruch 1, **dadurch gekennzeichnet, dass** die vorbestimmte Tiefe gleich oder größer als die Hälfte einer Dicke der Polysilikonschicht ist, oder die Isolationsnut die Polysilikonschicht durchdringt, oder die Isolationsnut die Polysilikonschicht und die Tunnelschicht durchdringt.

6. Verfahren zur Herstellung einer Solarzelle, **dadurch gekennzeichnet, dass** es umfasst:
Bereitstellen eines Siliziumsubstrats (S110);
aufeinanderfolgendes Ausbilden einer Tunnelschicht und einer Polysilikonschicht auf einer Rückseite des Siliziumsubstrats (S120);
Ausbilden einer dielektrischen Schicht auf einer Rückseite der Polysilikonschicht (S130);
Ausbilden einer ersten Elektrode und einer zweiten Elektrode, die die dielektrische Schicht durchdringen und mit der Polysilikonschicht in Kontakt stehen, wobei die erste Elektrode ein Dotierelement ersten Typs enthält und die zweite Elektrode ein Dotierelement zweiten Typs enthält (S140); und
Ausbilden eines ersten dotierten Bereichs und eines zweiten dotierten Bereichs, wobei ein Verfahren zum Ausbilden des ersten dotierten Bereichs und des zweiten dotierten Bereichs umfasst: Durchführen einer Wärmebehandlung an der ersten Elektrode und der zweiten Elektrode (S150).

7. Verfahren nach Anspruch 6, **dadurch gekennzeichnet, dass** die dielektrische Schicht Wasserstoff enthält, vorzugsweise Tempern der dielektrischen Schicht, um den Wasserstoff in der dielektrischen Schicht in die Polysilikonschicht, die Tunnelschicht und das Siliziumsubstrat zu diffundieren.

8. Verfahren nach Anspruch 6, **dadurch gekennzeichnet, dass** der erste dotierte Bereich von der ersten Elektrode ausgeht und sich bis in ein Inneres des Siliziumsubstrats erstreckt, und der zweite dotierte Bereich von der zweiten Elektrode ausgeht und sich bis in das Innere des Siliziumsubstrats erstreckt.

9. Verfahren nach Anspruch 8, **dadurch gekennzeichnet, dass** eine Breite des ersten dotierten Bereichs, der in dem Siliziumsubstrat angeordnet ist, gleich oder größer als eine Breite des ersten dotierten Bereichs ist, der in der Polysilikonschicht angeordnet ist, und die Breite des ersten dotierten Bereichs, der in der Polysilikonschicht angeordnet ist, gleich oder größer als eine Breite eines Kontaktbereichs zwischen der ersten Elektrode und der Polysilikonschicht ist, und/oder eine Breite des zweiten dotierten Bereichs, der in dem Siliziumsubstrat angeordnet ist, gleich oder größer als eine Breite des zweiten dotierten Bereichs ist, der in der Polysilikonschicht angeordnet ist, und die Breite des zweiten dotierten Bereichs, der in der Polysilikonschicht angeordnet ist, gleich oder größer als eine Breite eines Kontaktbereichs zwischen der ersten Elektrode und der Polysilikonschicht ist.

10. Verfahren nach Anspruch 9, **dadurch gekennzeichnet, dass** die Tunnelschicht eines oder mehrere von Siliziumdioxid, Siliziumnitrid, Siliziumoxynitrid und Aluminiumoxid umfasst, und die Polysilikonschicht intrinsisches Polysilizium umfasst.

11. Verfahren nach Anspruch 10, **dadurch gekennzeichnet, dass** ein Mindestabstand zwischen dem ersten dotierten Bereich und dem zweiten dotierten Bereich gleich oder größer als 30 µm ist.

12. Verfahren nach Anspruch 6, **dadurch gekennzeichnet, dass** die Polysilikonschicht eines oder mehrere von Sauerstoff, Kohlenstoff und Stickstoff umfasst.

13. Verfahren nach Anspruch 6, **dadurch gekennzeichnet, dass** vor dem Ausbilden der dielektrischen Schicht das Ausbilden einer Isolationsnut zwischen dem ersten dotierten Bereich und dem zweiten dotierten Bereich erfolgt, wobei die Isolationsnut in die Polysilikonschicht mindestens bis zu einer vorbestimmten Tiefe eindringt, vorzugsweise die dielektrische Schicht einen Boden und eine Seitenwand der Isolationsnut bedeckt.

14. Verfahren nach Anspruch 13, **dadurch gekennzeichnet, dass** ein Verfahren zum Ausbilden der Isolationsnut umfasst:
Ausbilden einer anfänglichen Isolationsnut, die eine korrosionsbeständige Schicht durchdringt, und die anfängliche Isolationsnut die Polysilikonschicht freilegt, wobei die korrosionsbeständige Schicht eine oder mehrere Schichten aus einer Siliziumoxidschicht, einer Siliziumnitridschicht und einer Aluminiumoxidschicht umfasst; und
Durchführen eines Texturierungsprozesses auf einer Vorderseite des Siliziumsubstrats, und der Texturierungsprozess ätzt die durch die anfängliche Isolationsnut freigelegte Polysilikonschicht, um die Isolationsnut auszubilden;
vorzugsweise vor dem Durchführen des Texturierungsprozesses auf der Vorderseite des Siliziumsubstrats das Ausbilden der dielektrischen Schicht auf einer Rückseite der korrosionsbeständigen Schicht.

15. Verfahren nach Anspruch 14, **dadurch gekennzeichnet, dass** ein Boden der Isolationsnut eine Pyramidentextur aufweist.

16. Verfahren nach Anspruch 6, **dadurch gekennzeichnet, dass** ein Verfahren zum Ausbilden der Polysilikonschicht umfasst:
Ausbilden einer amorphen Siliziumschicht auf einer Rückseite der Tunnelschicht; und
Kristallisieren der amorphen Siliziumschicht, um die amorphe Siliziumschicht in die Polysilikonschicht umzuwandeln;
vorzugsweise nach dem Kristallisieren der amorphen Siliziumschicht und vor dem Durchführen eines Texturierungsprozesses auf der Vorderseite des Siliziumsubstrats das Ausbilden der dielektrischen Schicht auf einer Seite der Polysilikonschicht, die von dem Siliziumsubstrat abgewandt ist.

## Revendications

1. Cellule solaire, comprenant :
un substrat de silicium (110) ;
une couche tunnelisante (120) et une couche de polysilicium (130) qui sont formées successivement sur une face arrière du substrat de silicium ;
une couche diélectrique (140) qui est formée sur une face arrière (131) de la couche de polysilicium ;
une première électrode (150) et une deuxième électrode (160), la première électrode et la deuxième électrode qui pénètrent la couche diélectrique et sont en contact avec la couche de polysilicium ;
une première région dopée (170) et une deuxième région dopée (180), la première région dopée qui commence à partir de la première électrode et s'étend vers l'intérieur du substrat de silicium, et la deuxième région dopée qui commence à partir de la deuxième électrode et s'étend vers l'intérieur du substrat de silicium, et
une rainure d'isolation (210) qui est située entre la première région dopée et la deuxième région dopée, et la rainure d'isolation qui s'enfonce dans la couche de polysilicium au moins jusqu'à une profondeur prédéterminée,
**caractérisée en ce que**
la première électrode contient un élément dopant identique à un élément dopant dans la première région dopée, et la deuxième électrode contient un élément dopant identique à un élément dopant dans la deuxième région dopée.

2. Cellule solaire selon la revendication 1, **caractérisée en ce que** la couche tunnelisante comprend un ou plusieurs parmi le dioxyde de silicium, le nitrure de silicium, l'oxynitrure de silicium et l'oxyde d'aluminium, et la couche de polysilicium comprend du polysilicium intrinsèque.

3. Cellule solaire selon la revendication 1, **caractérisée en ce qu'**une largeur de la première région dopée qui est située dans le substrat de silicium est égale ou supérieure à une largeur de la première région dopée qui est située dans la couche de polysilicium, et la largeur de la première région dopée qui est située dans la couche de polysilicium est égale ou supérieure à une largeur d'une partie de contact entre la première électrode et la couche de polysilicium, et/ou une largeur de la deuxième région dopée qui est située dans le substrat de silicium est égale ou supérieure à une largeur de la deuxième région dopée qui est située dans la couche de polysilicium, et la largeur de la deuxième région dopée qui est située dans la couche de polysilicium est égale ou supérieure à une largeur d'une partie de contact entre la deuxième électrode et la couche de polysilicium.

4. Cellule solaire selon la revendication 1, **caractérisée en ce que** la couche diélectrique recouvre un fond et une paroi latérale de la rainure d'isolation, et/ou la couche diélectrique comprend un ou plusieurs parmi le dioxyde de silicium, le nitrure de silicium, l'oxynitrure de silicium et l'oxyde d'aluminium.

5. Cellule solaire selon la revendication 1, **caractérisée en ce que** la profondeur prédéterminée est égale ou supérieure à la moitié d'une épaisseur de la couche de polysilicium, ou la rainure d'isolation pénètre la couche de polysilicium, ou la rainure d'isolation pénètre la couche de polysilicium et la couche tunnelisante.

6. Procédé de fabrication d'une cellule solaire, **caractérisé en ce qu'**il comprend :
fournir un substrat de silicium (S110) ;
former successivement une couche tunnelisante et une couche de polysilicium sur une face arrière du substrat de silicium (S120) ;
former une couche diélectrique sur une face arrière de la couche de polysilicium (S130) ;
former une première électrode et une deuxième électrode qui pénètrent la couche diélectrique et sont en contact avec la couche de polysilicium, la première électrode contenant un élément dopant de premier type, et la deuxième électrode contenant un élément dopant de deuxième type (S140) ; et
former une première région dopée et une deuxième région dopée, dans lequel un procédé de formation de la première région dopée et de la deuxième région dopée comprend : effectuer un traitement thermique sur la première électrode et la deuxième électrode (S150).

7. Procédé selon la revendication 6, **caractérisé en ce que** la couche diélectrique contient de l'hydrogène, de préférence, recuire la couche diélectrique pour diffuser l'hydrogène dans la couche diélectrique vers la couche de polysilicium, la couche tunnelisante et le substrat de silicium.

8. Procédé selon la revendication 6, **caractérisé en ce que** la première région dopée commence à partir de la première électrode et s'étend vers l'intérieur du substrat de silicium, et la deuxième région dopée commence à partir de la deuxième électrode et s'étend vers l'intérieur du substrat de silicium.

9. Procédé selon la revendication 8, **caractérisé en ce qu'**une largeur de la première région dopée qui est située dans le substrat de silicium est égale ou supérieure à une largeur de la première région dopée qui est située dans la couche de polysilicium, et la largeur de la première région dopée qui est située dans la couche de polysilicium est égale ou supérieure à une largeur d'une partie de contact entre la première électrode et la couche de polysilicium, et/ou une largeur de la deuxième région dopée qui est située dans le substrat de silicium est égale ou supérieure à une largeur de la deuxième région dopée qui est située dans la couche de polysilicium, et la largeur de la deuxième région dopée qui est située dans la couche de polysilicium est égale ou supérieure à une largeur d'une partie de contact entre la première électrode et la couche de polysilicium.

10. Procédé selon la revendication 9, **caractérisé en ce que** la couche tunnelisante comprend un ou plusieurs parmi le dioxyde de silicium, le nitrure de silicium, l'oxynitrure de silicium et l'oxyde d'aluminium, et la couche de polysilicium comprend du polysilicium intrinsèque.

11. Procédé selon la revendication 10, **caractérisé en ce qu'**une distance minimale entre la première région dopée et la deuxième région dopée est égale ou supérieure à 30 µm.

12. Procédé selon la revendication 6, **caractérisé en ce que** la couche de polysilicium comprend un ou plusieurs parmi l'oxygène, le carbone et l'azote.

13. Procédé selon la revendication 6, **caractérisé en ce qu'**avant de former la couche diélectrique, former une rainure d'isolation entre la première région dopée et la deuxième région dopée, dans lequel la rainure d'isolation s'enfonce dans la couche de polysilicium au moins jusqu'à une profondeur prédéterminée, de préférence la couche diélectrique recouvre un fond et une paroi latérale de la rainure d'isolation.

14. Procédé selon la revendication 13, **caractérisé en ce qu'**un procédé de formation de la rainure d'isolation comprend :
former une rainure d'isolation initiale qui pénètre une couche résistante à la corrosion, et la rainure d'isolation initiale qui expose la couche de polysilicium, la couche résistante à la corrosion comprenant une ou plusieurs couches parmi une couche d'oxyde de silicium, une couche de nitrure de silicium et une couche d'oxyde d'aluminium ; et
effectuer un processus de texturation sur une face avant du substrat de silicium, et le processus de texturation qui grave la couche de polysilicium exposée par la rainure d'isolation initiale pour former la rainure d'isolation ;
de préférence avant d'effectuer le processus de texturation sur la face avant du substrat de silicium, former la couche diélectrique sur une face arrière de la couche résistante à la corrosion.

15. Procédé selon la revendication 14, **caractérisé en ce qu'**un fond de la rainure d'isolation présente une texture pyramidale.

16. Procédé selon la revendication 6, **caractérisé en ce qu'**un procédé de formation de la couche de polysilicium comprend :
former une couche de silicium amorphe sur une face arrière de la couche tunnelisante ; et
cristalliser la couche de silicium amorphe pour convertir la couche de silicium amorphe en la couche de polysilicium ;
de préférence, après la cristallisation de la couche de silicium amorphe et avant d'effectuer un processus de texturation sur la face avant du substrat de silicium, former la couche diélectrique sur un côté de la couche de polysilicium qui est éloigné du substrat de silicium.
